(19) Europäisches Patentamt
European Patent Office
Office européen des brevets

(11) **EP 1 933 458 B1**

(12) **FASCICULE DE BREVET EUROPEEN**

(45) Date de publication et mention
de la délivrance du brevet:
**20.01.2010 Bulletin 2010/03**

(51) Int Cl.:
***H03H 17/00*** *(2006.01)*      ***F02D 41/02*** *(2006.01)*

(21) Numéro de dépôt: **07291438.5**

(22) Date de dépôt: **30.11.2007**

(54) **Resynchronisation de signaux moteur acquis temporellement**

Resynchronisation von zeitlich erfassten Motorsignalen

Resynchronisation of temporarily acquired engine signals

(84) Etats contractants désignés:
**DE GB IT**

(30) Priorité: **15.12.2006 FR 0610996**

(43) Date de publication de la demande:
**18.06.2008 Bulletin 2008/25**

(73) Titulaire: **IFP**
**92852 Rueil-Malmaison Cédex (FR)**

(72) Inventeurs:
• **Grouffal, Christian**
**92500 Rueil-Malmaison (FR)**
• **Thierry, Gérard**
**92000 Nanterre (FR)**

(56) Documents cités:
**EP-A1- 0 647 774     GB-A- 2 344 890**

**Description**

La présente invention concerne le domaine de l'analyse et du contrôle d'un moteur, et plus particulièrement le domaine de l'acquisition d'un signal issu d'au moins un capteur positionné sur un moteur.

Les diverses applications sur bancs d'essais moteur nécessitent l'acquisition d'un certain nombre de grandeurs physiques (pressions, températures, débits, etc.). Un moteur sous test est donc instrumenté avec un certain nombre de capteurs, chacun délivrant une tension ou un courant sous forme analogique vers un ou plusieurs systèmes d'acquisition de données ou de contrôle moteur.

De manière classique, le signal analogique issu du capteur est tout d'abord conditionné. A cette fin, il subit généralement une conversion en tension, une amplification puis un filtrage.

Le signal analogique obtenu est ensuite numérisé à l'aide d'un convertisseur analogique numérique, délivrant des échantillons codés généralement sur 12, 14 ou 16 bits. Dans le domaine de l'acquisition de signaux moteur, c'est-à-dire des signaux en provenance de capteurs positionnés sur un moteur, le signal de déclenchement des conversions est dépendant de la rotation du vilebrequin et provient généralement soit d'un codeur angulaire situé en bout de vilebrequin, soit d'une cible moteur (58X ou autre) positionnée également en bout de vilebrequin. Ainsi, la conversion analogique numérique des signaux peut s'effectuer tous les 6° vilebrequin, tous les degrés vilebrequin ou tous les 1/10 de degrés vilebrequin. La suite des différents échantillons obtenus est ensuite utilisée pour calculer différents paramètres utiles à l'analyse de la combustion ou au contrôle moteur. Ces calculs peuvent s'effectuer soit sur un cycle moteur correspondant à une ou plusieurs rotations du vilebrequin, soit sur plusieurs cycles moteur.

Toutefois, certains calculs nécessitent un échantillonnage temporel afin de respecter la théorie du signal des signaux échantillonnés. Ces calculs sont basés sur des algorithmes de traitement du signal (transformées de Fourier, filtrages, transformées en ondelettes, etc.). On peut citer par exemple l'analyse de bruit. Ainsi, le signal issu d'un capteur nécessite deux échantillonnages : un échantillonnage temporel et un échantillonnage synchronisé sur la rotation moteur.

Cependant, il est souvent nécessaire, pour certains calculs tels que l'analyse de combustion ou le calage du PMH (point mort haut), de corréler la position temporelle d'un échantillon avec la position angulaire du vilebrequin. Cette nécessité consiste à reconstituer à partir d'une acquisition temporelle et d'un signal de rotation vilebrequin la suite des échantillons comme s'ils provenaient d'un échantillonnage synchronisé sur la rotation vilebrequin. Cette opération implique actuellement la mise en oeuvre de moyens complexes de datation des échantillons, qu'ils soient matériel ou logiciel.

**État de la technique**

Par le document suivant, on connaît une technique permettant, à l'aide de calcul, de recaler ou rééchelonner des signaux dans le temps :

Laakso T.I. et al, "Splitting the Unit Delay", in IEEE Signal Processing Magazine, 1996. Cependant, cette technique de traitement de retard fractionnaire (inférieur à l'unité) décrit un filtre idéal qui ne peut être implémenté pour des applications de contrôle moteur ou de test sur banc d'essai, car sa réponse impulsionnelle est infiniment longue.

Le document EP-A-0 647 774 décrit un méthode de contrôle d'un moteur dans lequel des signaux moteurs sont synchronisés au moyen d'un déphaseur. Le méthode ne comprend pas l'utilisation d'un filtre numérique fractionnaire.

Ainsi, l'objet de l'invention concerne une méthode permettant de synchroniser un signal issu d'un capteur positionné sur un moteur avec un évènement périodique du moteur, tel que la rotation du vilebrequin, de façon suffisamment rapide pour être utilisée dans des applications moteurs.

**La méthode selon l'invention**

L'invention concerne une méthode de contrôle d'un moteur dans laquelle on acquiert à partir d'un capteur positionné sur ledit moteur un signal $S(t)$ caractérisant le fonctionnement dudit moteur, et l'on synchronise ledit signal $S(t)$ avec un évènement périodique dudit moteur. La méthode comporte les étapes suivantes :

- on produit une première série d'échantillons $E(t_i)$ en numérisant et échantillonnant ledit signal moteur $S(t)$ à des instants $t_i$ ;

- on acquiert un signal de synchronisation indicatif d'un instant de référence (TR) fonction dudit évènement périodique du moteur ;

- on mesure un écart de temps effectif D entre l'instant de référence (TR) et l'instant le plus récent (TP) parmi les instants $t_i$ ;

- on calcule des coefficients d'un filtre numérique fractionnaire (FSDF) propre à compenser l'écart de temps effectif mesuré, les coefficients étant en nombre suffisant pour obtenir une précision fixée de compensation en temps ; et

- on applique ledit filtre à la première série d'échantillons $E(t_i)$, pour obtenir une seconde série d'échantillons $E_{sync}(t_i)$ numérisés et rééchelonnés depuis l'instant de référence (TR) ;

- on contrôle ledit moteur en fonction de ladite seconde série d'échantillons $E_{sync}(t_i)$.

Le calcul des coefficients du filtre fractionnaire peut comporter une détermination de marges d'ondulation de l'amplitude $\Delta D$ et de la phase $a$ en fonction d'une erreur temporelle maximale $E_M$ affectant le signal décalé par le filtre $E_{sync}(t_i)$ par application de la relation suivante :

$$E_M \approx \sqrt{\left[ (\Delta D)^2 + (a)^2 \right]}$$

Le calcul des coefficients du filtre fractionnaire peut comporter les étapes suivantes :

- on précalcule des valeurs des coefficients de N filtres numériques intermédiaires (F1 à FN) propres à compenser N valeurs d'écart de temps effectif réparties sur la durée du pas d'échantillonnage du signal $S(t)$ issu du moteur par un convertisseur analogique-numérique et on mémorise ces coefficients de filtrage ;

- on calcule les coefficients du filtre numérique fractionnaire (FSDF) par interpolation entre les coefficients des séries de coefficients de filtrage associés aux valeurs d'écart les plus proches.

Selon l'invention on peut calculer les coefficients du filtre numérique par une interpolation de Lagrange.
Enfin, le signal de synchronisation peut être un signal dépendant de la rotation du vilebrequin.

**Présentation succincte de la figure**

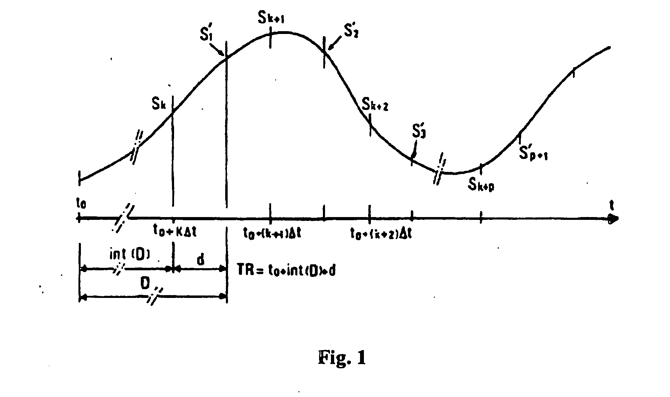

D'autres caractéristiques et avantages de la méthode selon l'invention, apparaîtront à la lecture de la description d'exemples non limitatifs de réalisations, en se référant à la figure 1 illustrant le rééchelonnement d'une série d'échantillons.

**Description détaillée de la méthode**

L'objet de l'invention concerne une méthode permettant de synchroniser un signal issu d'un capteur positionné sur un moteur avec un évènement périodique du moteur tel que la rotation du vilebrequin.
Dans un premier temps, à l'aide d'un capteur positionné sur un moteur, on acquiert un signal analogique mesurant directement ou indirectement un certain nombre de grandeurs physiques, telles que les pressions dans les cylindres, des températures, des débits, etc. On peut par exemple positionner un accéléromètre sur le bloc moteur, un capteur mesurant le régime instantanée au bout de la transmission, ou encore, un capteur mesurant la richesse du gaz d'échappement positionné sur le circuit d'échappement. De façon générale, ces capteurs délivrent une tension ou un courant sous forme analogique vers un ou plusieurs systèmes d'acquisition de données ou de contrôle moteur. Cette étape fournit un signal analogique $S(t)$ en fonction du temps $t$.
Puis, le signal analogique ainsi acquis $S(t)$ est numérisé de façon à être interprété par des dispositifs électroniques de contrôle moteur ou d'analyse de la combustion. Cette numérisation est réalisée par un signal de déclenchement. Selon l'invention, ce signal de déclenchement des conversions dépend du temps $t$. Ainsi, en fonction du temps, un signal est envoyé à un convertisseur numérique pour obtenir des échantillons en fonction du temps à partir du signal analogique $S(t)$. Cette étape fournit une suite d'échantillons $E(t_i)$, où $E$ représente la valeur numérisée du signal $S(t)$, $t_i$ représente un temps. Une valeur $E(t_i)$ correspond ainsi à la valeur numérisée du signal $S(t)$ au temps $t_i$. On obtient donc un signal échantillonné pour les temps $t_1$, $t_2$, ..., $t_n$ : $E(t_1)$, $E(t_2)$, ..., $E(t_n)$.
Enfin, le signal numérique ainsi échantillonné en temps $E(t_i)$ est synchronisé à partir d'un instant de référence (TR), fonction de l'angle vilebrequin $\alpha$ par exemple. Cette étape peut se décomposer en quatre phases principales :

1. Acquisition d'un signal de synchronisation indicatif de cet instant de référence (TR) ;

2. Mesure de l'écart de temps effectif (D) entre l'instant de référence (TR) et l'instant le plus récent (TP) parmi les $t_i$ ;

3. Construction d'un filtre numérique fractionnaire (FSDF) propre à compenser l'écart de temps effectif mesuré (D) ;

4. Application à la série d'échantillons $E(t_i)$ du filtre numérique de compensation fractionnaire (FSDF), pour obtenir une série d'échantillons $E_{sync}(t_i)$ numérisés rééchelonnée depuis l'instant de référence (TR). Ces étapes sont décrites en détail ci-après.

1- Acquisition d'un signal de synchronisation

Il est donc tout d'abord nécessaire d'acquérir un signal de synchronisation indicatif d'un instant de référence (TR) sur lequel on souhaite synchroniser le signal numérique $E(t_i)$ échantillonné en temps. On peut utiliser un signal de rotation du vilebrequin échantillonné en fonction du temps. Ceci est classiquement réalisé à partir, soit d'un codeur angulaire situé en bout de vilebrequin, soit d'une cible moteur (58X ou autre) positionnée également en bout de vilebrequin. On obtient ainsi une suite d'échantillons $\alpha(t_i')$, où $\alpha$ représente l'angle vilebrequin, $t_i'$ représente un temps.

Une valeur $\alpha(t_i')$ correspond ainsi à la valeur de l'angle vilebrequin au temps $t'_i$. On obtient donc un signal échantillonné pour les temps $t_1'$, $t_2'$, ..., $t_m'$ : $\alpha(t_1')$, $\alpha(t_2')$, ..., $\alpha(t_m')$.

Ensuite, la synchronisation est réalisée à partir d'un instant de référence *(TR)*. Cet instant dépend du signal $\alpha(t_i')$. Par exemple, lorsque le signal de rotation vilebrequin échantillonné $\alpha(t_i')$, indique que l'angle vilebrequin vaut une certaine valeur $\alpha(TR)$, un signal est envoyé pour synchroniser le signal échantillonné en temps $E(t_i)$ sur la rotation vilebrequin $\alpha(t_i')$. Il s'agit alors d'obtenir une série d'échantillons $E_{sync}(t_i)$, rééchelonnée depuis l'instant de référence *TR*, à partir de la première série $E(t_i)$ d'échantillons numérisés de ce signal moteur produits depuis un instant initial $(t_1)$ quelconque antérieur à l'instant de référence *(TR)*.

2- Mesure de l'écart de temps (D) entre l'instant de référence (TR) et l'instant le plus récent

On détermine l'échantillon temporel numérisé $E(TP)$ le plus récent par rapport à l'instant de référence *TR,* c'est-à-dire l'échantillon parmi les échantillons $E(t_1)$, $E(t_2)$, ..., $E(t_n)$ pour lequel $t_i$ est le plus proche de *TR.* L'échantillon $E(TP)$ est l'échantillon temporellement le plus proche de l'échantillon $\alpha(TR)$.
Ensuite, on calcule le retard de temps effectif, noté $D$, entre l'instant de référence *TR* et l'instant le plus récent *TP : D = TR - TP*

3- Calcul de coefficients d'un filtre numérique fractionnaire (FSDF)

Selon l'invention, on compense cet écart de temps effectif mesuré (*D*), en construisant un filtre à retard fractionnaire (FSDF) que l'on applique à la série d'échantillons $E(t_i)$. Les coefficients de ce filtre sont en nombre suffisant pour obtenir une précision fixée de compensation en temps.

*Principe*

Le principe est illustré par la figure 1. On désigne par x[n] une série d'échantillons numérisés $S_k$, $S_{k+1}$, $S_{k+2}$... $S_{k+p}$, issus d'un signal de mesure depuis un instant initial $t_0$, avec un pas d'échantillonnage $\Delta t$, par un convertisseur analogique-numérique et par y[n] une série d'échantillons $S'_1$, $S'_2$, $S'_3$... $S'_{P+1}$, prélevés avec le même pas sur le même signal de mesure mais rééchelonnés dans le temps à partir d'un instant de référence $T_R$ postérieur à $t_0$. L'écart de temps de recalage D est un nombre réel positif. On doit avoir : y[n] = x[n-D]
En règle générale, le retard D peut être décomposé en une partie entière (nombre entier d'échantillons) et une partie fractionnaire :

$$D = \text{int}(D) + d$$

où int($D$) correspond à un nombre entier de périodes d'échantillonnage et d est une fraction de période.

Pour obtenir un retard int($D$), il suffit de retarder le signal initial x[n] par une simple translation. Les échantillons de y[n] sont ceux de x[n] simplement décalés en indice (renumérotés) de int($D$). L'échantillon numéroté k dans la première série par exemple, devient l'échantillon numéroté 1 dans la deuxième série, avec k. $\Delta t$ = int(D). Pour la partie fractionnaire de cet écart de temps, les échantillons recalés y[n] seront quelque part entre les valeurs de x[n] à deux positions successives d'échantillonnage par l'horloge locale et doivent correspondre au mieux aux amplitudes effectives des signaux échantillonnés à ces positions intermédiaires. Ce décalage avec rééchelonnement peut être obtenu par application d'un filtrage numérique $H_{id}$.

Avec les notations propres à la transformée en Z (bien connue des spécialistes), ce décalage par filtrage numérique peut être formulé ainsi : $Y(z) = X(z).z^{-D}$

La réponse en fréquence du filtre idéal $H_{ID}$ est : $H_{id} = z^{-D} = e^{-j\omega D}$ avec $z = e^{-j\omega}$

Les réponses en amplitude et en phase du filtre idéal pour tout $\omega$ sont donc :

$$\left|H_{id}\left(e^{j\omega}\right)\right| = 1 \ \text{ et } \ \arg\left[H_{id}\left(e^{j\omega}\right)\right] = \theta_{id}(\omega) = -D\omega$$

La phase est souvent représentée sous la forme d'un retard de phase défini par :

$$\tau_p(\omega) = -\frac{\theta_{id}(\omega)}{\omega},$$

retard ici égal à D.

La réponse impulsionnelle correspondante est obtenue par transformée de Fourier inverse :

$$h_{id}[n] = \frac{1}{2\pi}\int_{-\pi}^{\pi}H_{id}\left(e^{j\omega}\right)e^{j\omega n\Delta t}d\omega$$

pour tout n, d'où :

$$h_{id}[n] = \frac{\sin[\pi(n\Delta t - D)]}{\pi(n\Delta t - D)} = \sin c(n\Delta t - D)$$

pour tout n.

Ce filtre idéal $H_{ID}$, décrit dans Laakso T.I. et al (cité précédemment), ne peut pas être implémenté car sa réponse impulsionnelle est infiniment longue. Selon l'invention, on utilise alors un filtre à retard fractionnaire, noté FSDF (« *fractional-sample delay filter* »), pour s'approcher de cette solution idéale suffisamment près pour que la précision du recalage ou rééchelonnement dans le temps, reste compatible avec la précision attendue dans la pratique.

*Contraintes*

La résolution du problème consiste alors à implémenter un filtre à retard fractionnaire ayant des contraintes bien définies en fonction de l'application. En effet, la méthode de filtrage mise en oeuvre répond à certains impératifs liés à l'application moteur: bande passante des signaux à acquérir, fréquence d'échantillonnage, limitations techniques des moyens d'application du filtrage numérique (moyens de calcul) disponibles et précision attendue dans le calcul des échantillons recalés.

*Calcul des coefficients du filtre fractionnaire*

La méthode repose sur la construction d'un filtre à retard fractionnaire (FSDF) via le calcul de ses coefficients. Ce calcul se base sur le filtre idéal définit précédemment ($H_{ID}$).

L'erreur temporelle maximale $E_M$ point par point entre le signal décalé calculé par le filtre et le signal décalé idéal (pour lequel $E_M=0$) peut s'exprimer par la relation:

$$E_M \approx \sqrt{\left[(\Delta D)^2 + (a)^2\right]} \qquad (1)$$

avec :

- $\Delta D$ la marge d'ondulation à l'intérieur de la bande passante en ce qui concerne la phase ;

- $a$ la marge d'ondulation à l'intérieur de la bande passante en ce qui concerne l'amplitude.

Ceci pourvu que le signal soit dans la bande de fréquence inférieure à la fréquence de coupure du filtre.
Connaissant cette relation entre l'erreur maximale et les caractéristiques de filtrage, on sélectionne alors une méthode connue de conception de filtres F.I.R (Finite Impulse Response) donnant les coefficients du filtre appropriés. Les filtres FIR sont des filtres non récursifs sans contre réaction. Le système numérique apparaît comme une fenêtre centrée sur les N plus récents échantillons. Ce filtre a une mémoire de longueur N. Une méthode connue d'un tel filtre est la méthode d'interpolation de Lagrange. Cette méthode est bien connue des spécialistes, on peut par exemple se référer au document suivant :

OONO Y, 1996, "Formulation of the design of FIR filters on the basis of the Lagrange interpolation formula", International journal of circuit theory and applications, 1996, vol. 24, no5, pp. 581-585

Si l'on dispose par exemple d'un convertisseur analogique-numérique fonctionnant sur 16 bits dont un bit de signe, on peut imposer que l'erreur soit au plus égale à un pas de quantification soit $2^{-15} \approx 10^{-5}$.

Pour une erreur de $10^{-5}$, il faut que $a$ soit de l'ordre de $10^{-5}$, ce qui impose que la marge d'ondulation $|H|$ de la fonction de filtrage soit telle que : $1-a \leq |H| \leq 1+a$. Comme $a$ est très petit, on montre aisément que cette inégalité équivaut à : $-10^{-5} \leq |H|_{dB} \leq 10^{-5}$. La même relation montre que $|\Delta D|$ doit aussi être de l'ordre de $10^{-5}$.
Avec les spécifications précédentes, convenant pour des applications en contrôle moteur, le traitement de signaux moteur échantillonnés à 0,1° vilebrequin à 6000 tours/min impose pour l'échantillonnage temporel une bande passante minimum de 333 KHz. Nous prendrons à titre d'exemple et comme hypothèse de discussion :

- fréquence de coupure caractérisée par deux valeurs, 375 KHz et 420 KHz ;

- oscillations dans la bande de fréquence [0, 375 KHz] inférieures à 0.05 dB ;

- oscillations dans la bande de fréquence [0, 420 KHz] inférieures à 0.2 dB ;

- fréquence de coupure en phase égale à 375 KHz ;

- oscillations dans la bande de fréquence [0, 375 KHz] inférieures à un retard correspondant à un retard temporel de 0,01 μs, la spécification en phase correspondant à 0,01 μs pour une fréquence d'échantillonnage de 1000 KHz (donc une période temporelle de 1 μs) donne un retard fractionnaire de $0,01/2 = 10^{-2}$

On vérifie donc que ces contraintes en amplitude et en phase sont largement satisfaites si l'on impose que l'erreur soit inférieure à $10^{-5}$.
Il s'agit ensuite de déterminer la valeur des coefficients du filtre de décalage, compte tenu des limitations imposées, en choisissant comme on l'a dit, parmi des méthodes de conception de filtre bien connues des spécialistes. La méthode la plus simple pour implémenter un filtre à retard fractionnaire consiste à utiliser la méthode d'interpolation de Lagrange qui offre une très bonne réponse en fréquence et une réponse en amplitude très plate pour les basses fréquences mais le filtre résultant a une bande passante très étroite, variant peu avec l'ordre du filtre. On connaît aussi les méthodes de fenêtrage temporel (fenêtre de Kaiser, de Dolph-Tchebichev, de Blackman, de Hamming, etc.). Une autre méthode connue dite des moindres carrés consiste essentiellement à minimiser l'erreur fréquentielle entre le filtre idéal $H_{ID}$ et le filtre FSDF implémenté. Les programmes de calcul nécessaires au calcul des coefficients de filtrage selon ces différentes méthodes, sont le plus souvent disponibles dans des bibliothèques connues de logiciels de traitement du signal telles que Matlab™ par exemple.

Pour chaque valeur particulière du retard, un rééchantillonnage permettant une approximation avec une précision de l'ordre de 10^-7, nécessite le calcul d'un filtre défini par plusieurs dizaines de coefficients de filtrage. Il en faut 60 par exemple par la méthode des moindres carrés généralisés pour atteindre une précision de cet ordre.

Le filtre numérique fractionnaire ainsi construit (FSDF) est propre à compenser l'écart de temps effectif mesuré, les coefficients étant en nombre suffisant pour obtenir une précision fixée de compensation en temps.

4- Application du filtre numérique de compensation fractionnaire (FSDF)

En appliquant le filtre FSDF ainsi construit aux échantillons $E(t_i)$, on obtient la série d'échantillons $E_{sync}(t_i)$ synchronisés sur l'instant de référence (TR).

Cette méthode donne ainsi une estimation des échantillons du signal, cette estimation représente le signal réel si dans la conception du système, la marge d'erreur tolérée est inférieure à la précision du convertisseur.

**Application**

La conception du filtre numérique à retard fractionnaire respectant les contraintes exposées précédemment (bande passante des signaux à acquérir, fréquence d'échantillonnage...) aboutit d'une part à un nombre important de coefficients, et d'autre part au codage des coefficients sous forme de nombres flottants 32 bits. Les calculs permettant d'obtenir les échantillons de sortie à partir de la mesure du retard D et des échantillons d'entrée du filtre doivent également se faire en flottant 32 bits. En outre, les calculs doivent être effectués à chaque demande de synchronisation sur le signal rotation moteur.

Quelle que soit la méthode utilisée pour la conception du filtre à retard fractionnaire, les temps de calcul les plus importants concernent la détermination des coefficients du filtre car ces calculs comportent soit un grand nombre d'opérations, soit font appel à des fonctions mathématiques trigonométriques, soit encore au calcul matriciel. Il est donc impossible de calculer ces coefficients en temps réel. En effet, pour un échantillonnage angulaire au 1/10° à 6000 tours/min, un échantillon de sortie doit être délivré toutes les 2,8 μsec. La solution retenue ici consiste donc à pré calculer les coefficients du filtre considéré pour un nombre limité de valeurs de D. On pourra par exemple prendre une dizaine de valeurs de D régulièrement réparties ou non entre 0 et 1. Ces valeurs sont stockées sous forme de table dans le matériel ou logiciel du système (10 dans le cas cité en exemple). Les coefficients du filtre évoluant de manière monotone en fonction de D, on calcule par interpolation à partir de la table la plus proche les valeurs des coefficients du filtre. A titre d'exemple, une interpolation de Lagrange d'ordre 5 donne des résultats satisfaisants en accord avec les contraintes du problème. Ensuite, la convolution des échantillons d'entrée avec les coefficients déterminés s'implémente par une série de multiplications additions. Cette implémentation peut se faire de manière purement matériel, dans un réseau prédiffusé de portes logiques programmable par l'utilisateur, appelé FPGA (field programmable gate array) ou de manière purement logiciel dans un processeur de signal numérique (DSP), c'est-à-dire un processeur conçu spécialement pour traiter à grande vitesse et en temps réel des signaux numériques issus de la conversion de signaux analogiques.

Le principe ci-dessus permet l'acquisition de données propres au moteur lors des démarrages à froid. En effet, les signaux de synchronisation angulaire ne sont disponibles qu'au bout de un à deux cycles moteur. Par conséquent, il est impossible d'échantillonner le signal dès le début. Toutefois, les signaux de synchronisation angulaire peuvent être reconstitués à posteriori. Grâce à l'acquisition temporelle et à un stockage des échantillons temporels en mémoire, le système est alors capable de délivrer des échantillons synchronisés angulairement en utilisant la méthode décrite ci-dessus.

Le principe ci-dessus permet également d'obtenir une précision plus importante de l'échantillonnage angulaire lors des bas régimes ou du ralenti. En effet, la méthode peut s'appliquer pour des échantillonnages angulaires inférieurs au 1/10 ° vilebrequin.

Enfin, l'invention a été décrite dans le cadre d'une synchronisation sur l'angle vilebrequin, mais tout autre signal de synchronisation, utile au contrôle moteur ou l'analyse de la combustion peut servir de base à cette synchronisation. La méthode permet de resynchroniser des échantillons acquis de manière temporelle par tout autre signal externe provenant d'un capteur installé sur le moteur (Arbre à cames par exemple) ou d'une horloge externe fonctionnant à une fréquence d'échantillonnage différente de la fréquence d'échantillonnage du capteur. Corollairement, on peut découpler complètement l'acquisition temporelle sur les capteurs et envisager des fréquences d'échantillonnage temporelle des capteurs quelconques et différentes d'un capteur à l'autre, mais fournir au système d'acquisition ou de contrôle moteur un ensemble de signaux cohérents parfaitement resynchronisés de manière angulaire ou rééchantillonnés dans le temps.

## EP 1 933 458 B1

**Revendications**

1. Méthode de contrôle d'un moteur, dans laquelle on acquiert à partir d'un capteur positionné sur ledit moteur un signal $S(t)$ caractérisant le fonctionnement dudit moteur, et l'on synchronise ledit signal $S(t)$ avec un évènement périodique dudit moteur, **caractérisée en ce qu'**elle comporte les étapes suivantes:

   - on produit une première série d'échantillons $E(t_i)$ en numérisant et échantillonnant ledit signal moteur $S(t)$ à des instants $t_i$ ;
   - on acquiert un signal de synchronisation indicatif d'un instant de référence (TR) fonction dudit événement périodique du moteur ;
   - on mesure un écart de temps effectif D entre l'instant de référence (TR) et l'instant le plus récent (TP) parmi les instants $t_i$ ;
   - on calcule des coefficients d'un filtre numérique fractionnaire (FSDF) propre à compenser l'écart de temps effectif mesuré, les coefficients étant en nombre suffisant pour obtenir une précision fixée de compensation en temps ; et
   - on applique ledit filtre à la première série d'échantillons $E(t_i)$, pour obtenir une seconde série d'échantillons $E_{sync}(t_i)$ numérisés et rééchelonnés depuis l'instant de référence (TR);
   - on contrôle ledit moteur en fonction de ladite seconde série d'échantillons $E_{sync}(t_i)$.

2. Méthode selon la revendication 1, dans laquelle le calcul des coefficients du filtre fractionnaire comporte une détermination de marges d'ondulation de l'amplitude $\Delta D$ et de la phase $a$ en fonction d'une erreur temporelle maximale $E_M$ affectant le signal décalé par le filtre $E_{sync}(t_i)$ par application de la relation suivante :

$$E_M \approx \sqrt{\left[(\Delta D)^2 + (a)^2\right]}$$

3. Méthode selon la revendication 1 ou 2, dans laquelle le calcul des coefficients du filtre fractionnaire comporte les étapes suivantes :

   - on précalcule des valeurs des coefficients de N filtres numériques intermédiaires (F1 à FN) propres à compenser N valeurs d'écart de temps effectif réparties sur la durée du pas d'échantillonnage du signal $S(t)$ issu du moteur par un convertisseur analogique-numérique et on mémorise ces coefficients de filtrage ;
   - on calcule les coefficients du filtre numérique fractionnaire (FSDF) par interpolation entre les coefficients des séries de coefficients de filtrage associés aux valeurs d'écart les plus proches.

4. Méthode selon l'une des revendications précédentes, dans laquelle on calcule les coefficients du filtre numérique par une interpolation de Lagrange.

5. Méthode selon l'une des revendications précédentes, dans laquelle le signal de synchronisation est un signal dépendant de la rotation du vilebrequin.

**Claims**

1. Method of controlling an engine, wherein a signal $S(t)$ characterizing the operation of said engine is acquired from a sensor positioned on said engine and said signal $S(t)$ is synchronized with a periodic event of said engine, **characterized in that** it comprises the following stages:

   - producing a first series of samples $E(t_i)$ by digitizing and by sampling said engine signal $S(t)$ at times $t_i$,
   - acquiring a synchronization signal indicative of a reference time (TR) that is a function of said periodic event of the engine,
   - measuring an effective time difference D between reference time (TR) and the most recent time (TP) among the times $t_i$,
   - calculating coefficients of a fractional digital filter (FSDF) suited to compensate for the measured effective time difference, the coefficients being in sufficient number to obtain a fixed time compensation precision,
   - applying said filter to the first series of samples $E(t_i)$ to obtain a second series of digitized samples $E_{sync}(t_i)$

rescaled from reference time (TR), and
- controlling said engine according to said second series of samples $E_{sync}(t_i)$.

2. A method as claimed in claim 1, wherein calculation of the fractional filter coefficients involves determining ripple margins of the amplitude $\Delta D$ and of phase $a$ as a function of a maximum temporal error $E_M$ affecting the signal delayed by the filter $E_{sync}(t_i)$ by applying the relation as follows:

$$E_M \approx \sqrt{\left[(\Delta D)^2 + (a)^2\right]}.$$

3. A method as claimed in claim 1 or 2, wherein calculation of the fractional filter coefficients involves the following stages:

- precalculating values of the coefficients of N intermediate digital filters (F1 to FN) suited to compensate for N effective time difference values distributed over the duration of the sampling interval of signal $S(t)$ coming from the engine by means of an analog-to-digital converter and storing these filter coefficients,
- calculating the coefficients of the fractional digital filter (FSDF) by interpolation between the coefficients of the series of filtering coefficients associated with the closest difference values.

4. A method as claimed in any one of the previous claims, wherein the digital filter coefficients are calculated by means of a Lagrange interpolation.

5. A method as claimed in any one of the previous claims, wherein the synchronization signal is a signal depending on the crankshaft rotation.

**Patentansprüche**

1. Verfahren zur Steuerung eines Motors, wobei von einem Sensor, der in diesem Motor angeordnet ist, ein Signal S(t) erfasst wird, das den Betrieb des Motors charakterisiert, und dieses Signal S(t) mit einem periodischen Ereignis dieses Motors synchronisiert wird, **dadurch gekennzeichnet, dass** es die folgenden Schritte umfasst:

- das Erzeugen einer ersten Reihe von Abtastwerten $E(t_1)$, indem dieses Motorsignal S(t) an Zeitpunkten $t_i$ digitalisiert und abgetastet wird;
- das Erfassen eines Synchronisiersignals, das einen Bezugszeitpunkt (TR) abhängig vom periodischen Ereignis dieses Motors anzeigt;
- das Messen einer effektiven Zeitabweichung D zwischen dem Bezugszeitpunkt (TR) und dem letzten Zeitpunkt (TP) unter den Zeitpunkten $t_i$;
- das Berechnen der Koeffizienten eines digitalen Teilfilters (FSDF), die geeignet sind, die gemessene Zeitabweichung auszugleichen, wobei die Zahl der Koeffizienten ausreichend ist, um einen festgelegten Zeitausgleich zu erreichen; und
- das Awenden dieses Filters auf die erste Reihe von Abtastwerten $E(t_i)$, um eine zweite Reihe von Abtastwerten $E_{sync}(t_i)$ zu erhalten, die digitalisiert und ab dem Bezugszeitpunkt (TR) neu gestaffelt sind;
- das Steuern des Motors in Abhängigkeit von dieser zweiten Reihe von Abtastwerten $E_{sync}(t_i)$.

2. Verfahren nach Anspruch 1, wobei die Berechnung der Koeffizienten des Teilfilters eine Bestimmung von Welligkeitsbreiten der Amplitude $\Delta D$ und der Phase $\alpha$ in Abhängigkeit eines maximalen Zeitfehlers $E_M$ umfasst, der das vom Filter verschobene Signal $E_{sync}(t_i)$ betrifft, durch Anwendung der folgenden Relation:

$$E_M \approx \sqrt{\left[(\Delta D)^2 + (\alpha)^2\right]}$$

3. Verfahren nach Anspruch 1 oder 2, wobei die Berechnung der Koeffizienten des Teilfilters die folgenden Schritte umfasst:

- das Vorberechnen der Werte der Koeffizienten von N Zwischendigitalfiltern (F1 bis FN), die geeignet sind, N effektive Zeitabweichungswerte, die über die Dauer des Abtastschritts des Signals S(t) vom Motor verteilt sind, durch einen Analog-DigitalWandler, und das Speichern dieser Filterkoeffizienten;
- das Berechnen der Koeffizienten des digitalen Teilfilters (FSDF) durch Interpolation zwischen den Koeffizienten der Reihen von Filterkoeffizienten, die zu den nächsten Abweichungswerten gehören.

4. Verfahren nach einem der vorherigen Ansprüche, wobei die Koeffizienten des Digitalfilters durch eine Lagrange-Interpolation berechnet werden.

5. Verfahren nach einem der vorherigen Ansprüche, wobei das Synchronisiersignal ein von der Drehung der Kurbelwelle abhängiges Signal ist.

**Fig. 1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0647774 A

**Littérature non-brevet citée dans la description**

- **LAAKSO T.I. et al.** Splitting the Unit Delay. *IEEE Signal Processing Magazine,* 1996

- **OONO Y.** Formulation of the design of FIR filters on the basis of the Lagrange interpolation formula. *International journal of circuit theory and applications,* 1996, vol. 24 (5), 581-585